# EUROPEAN PATENT SPECIFICATION

(11) **EP 1 404 796 B1**
(45) Date of publication and mention of the grant of the patent: **15.02.2012**
(21) Application number: 02749817.9
(22) Date of filing: 08.07.2002
(51) Int. Cl.: C11D 7/32, C11D 7/50

(54) **AMMONIA-FREE ALKALINE MICROELECTRONIC CLEANING COMPOSITIONS WITH IMPROVED SUBSTRATE COMPATIBILITY**
AMMONIAKFREIE ALKALISCHE MIKROELEKTRONISCHE REINIGUNGSZUSAMMENSETZUNG MIT VERBESSERTER SUBSTRATVERTRÄGLICKEIT
COMPOSITIONS DE NETTOYAGE DE MICRO-ELEMENTS ELECTRONIQUES ALCALINES SANS AMMONIAC A COMPATIBILITE AVEC LES SUBSTRATS AMELIOREE

(30) Priority: 09.07.2001 US 304312 P
(43) Date of publication of application: 07.04.2004
(73) Proprietor: Avantor Performance Materials, Inc., Phillipsburg NJ 08865 (US)
(72) Inventor: HSU, Chien-Pin, Sherman, Basking Ridge, NJ 07920 (US)
(74) Representative: Westwood, Joanna
(86) International application number: PCT/US2002/021374
(87) International publication number: WO 2003/006597

(56) References cited:
- WO-A-88/05813
- WO-A-99/60448
- WO-A1-02/27409
- US-A- 4 744 834
- US-A- 5 091 103
- US-A- 6 110 881

## Description

### FIELD OF THE INVENTION

This invention relates to ammonia-free cleaning compositions for cleaning microelectronic substrates, and particularly to such cleaning compositions useful with and having improved compatibility with microelectronic substrates characterized by sensitive porous and low-κ and high-κ dielectrics and copper metallization. The invention also relates to the use of such cleaning compositions for stripping photoresists, cleaning residues from plasma generated organic, organometallic and inorganic compounds, and cleaning residues from planarization processes, such as chemical mechanical polishing (CMP), as well as an additive in planarization slurry residues.

### BACKGROUND TO THE INVENTION

Many photoresist strippers and residue removers have been proposed for use in the microelectronics field as downstream or back end of the manufacturing line cleaners. In the manufacturing process a thin film of photoresist is deposited on a wafer substrate, and then circuit design is imaged on the thin film. Following baking, the unpolymerized resist is removed with a photoresist developer. The resulting image is then transferred to the underlying material, which is generally a dielectric or metal, by way of reactive plasma etch gases or chemical etchant solutions. The etchant gases or chemical etchant solutions selectively attack the photoresist-unprotected area of the substrate. As a result of the plasma etching process, photoresist, etching gas and etched material by-products are deposited as residues around or on the sidewall of the etched openings on the substrate.

Additionally, following the termination of the etching step, the resist mask must be removed from the protected area of the wafer so that the final finishing operation can take place. This can be accomplished in a plasma ashing step by the use of suitable plasma ashing gases or wet chemical strippers. Finding a suitable cleaning composition for removal of this resist mask material without adversely affecting, e.g., corroding, dissolving or dulling, the metal circuitry has also proven problematic.

As microelectronic fabrication integration levels have increased and patterned microelectonic device dimensions have decreased, it has become increasingly common in the art to employ copper metallizations, porous, low-κ and high-κ dielectrics. These materials have presented additional challenges to find acceptable cleaner compositions. Many process technology compositions that have been previously developed for "traditional" or "conventional" semiconductor devices containing Al/SiO₂ or Al(Cu)/SiO₂ structures cannot be employed with copper metallized low-κ or high-κ dielectric structures. For example, hydroxylamine based stripper or residue remover compositions are successfully used for cleaning devices with Al metallizations, but are practically unsuitable for those with copper metallizations. Similarly, many copper metallized/ low-K strippers are not suitable for Al metallized devices unless significant adjustments in the compositions are made.

WO 99/60448 discloses an aqueous alkaline composition for stripping or cleaning semi-conductor wafers.

Removal of these etch and/or ash residues following the etch and/or ashing process has proved problematic. Failure to completely remove or neutralize these residues can result in the absorption of moisture and the formation of undesirable materials that can cause corrosion to the metal structures. The circuitry materials are corroded by the undesirable materials and produce discontinuances in the circuitry wiring and undesirable increases in electrical resistance.

The current back end cleaners show a wide range of compatibility with certain, sensitive dielectrics and metallizations, ranging from totally unacceptable to marginally satisfactory. Many of the current strippers or residue cleaners are not acceptable for advanced interconnect materials such as low-κ and high-κ dielectrics and copper metallizations. Additionally, the typical alkaline cleaning solutions employed are overly aggressive towards low-κ and high-κ dielectrics and/or copper metallizations. Moreover, many of these alkaline cleaning compositions contain organic solvents that show poor product stability, especially at higher pH ranges and at higher process temperatures.

### BRIEF SUMMARY OF THE INVENTION

There is, therefore, a need for microelectronic cleaning compositions suitable for back end cleaning operations which compositions are effective cleaners and are applicable for stripping photoresists, cleaning residues from plasma process generated organic, organometallic and inorganic materials, and cleaning residues from planarization process steps, such as chemical mechanical polishing and the like. This invention relates to compositions that are effective in stripping photoresists, preparing/cleaning semiconductor surfaces and structures with good compatibility with advanced interconnect materials and copper metallizations.

It has been discovered that ammonia (NH₃) and ammonia-derived bases such as ammonium hydroxide and other salts (NH₄X, X= OH, carbonate, etc.) are capable of dissolving /corroding metals such as copper through complex formation. Thus they are poor choices to be used in semiconductor cleaning formulations when compatibility with porous, low-κ and high-κ dielectrics and copper metallizations are required. These compounds can generate ammonia through equilibrium process. Ammonia can form complex with metals such as copper and result in metal corrosion/dissolution as set forth in the following equations.

NH₄X ↔ NH₃ + HX (Equation 1)

Cu + 2 NH₃ → [ Cu (NH₃)₂]⁺ → [ Cu (NH₃)₂]²⁺ (Equation 2)

Thus, ammonium hydroxide and ammonium salts can provide nucleophilic and metal-chelating ammonia (NH₃) through the equilibrium process described in Equation 1, particularly when other bases such as amines and alkanolamines are added. In the presence of oxygen, metals such as copper can be dissolved/corroded through complex formation with ammonia, as described in Equation 2. Such complex formation can further shift the equilibrium (Equation 1) to the right, and provide more ammonia, leading to higher metal dissolution/corrosion.

Generally, sensitive low-κ dielectrics degrade significantly under strong alkaline conditions. Ammonia and ammonia derived bases also show poor compatibility with sensitive dielectrics, such as hydrogen silsesquioxane (HSQ) and methyl silsesquioxane (MSQ). Again, they can provide ammonia and/or other nucleophiles, and thus lead to reaction/degradation of sensitive dielectrics.

It has been discovered that non-ammonia producing strong base alkaline cleaning formulations containing non-nucleophilic, positively charged counter ions (such as tetraalkylammonium) in steric hindered amide solvents show much improved compatibility with sensitive porous, low-κ and high-κ dielectrics and copper metallization. The preferred solvent matrices are resistant to strong alkaline conditions, due to steric hindrance effects and/or low or no reactivity to nucleophilic reactions (with respect to nucleophiles such as hydroxide ions). The improved dielectric compatibility is partially achieved due to the absence of undesirable nucleophiles in the compositions. Good compatibility with copper metallization is achieved by selective use of certain copper-compatible steric hindered amide solvents. These components can be formulated into semi-aqueous to practically non-aqueous (organic-solvent based) cleaning solutions or slurries.

The invention provides in a first aspect, a cleaning composition capable of cleaning residues from porous dielectrics, a low-κ dielectric, a high-κ dielectric or copper metallisation, said cleaning composition comprising:
from 0.05 to 30 % by weight of one or more non-ammonia producing strong base containing non-nucleophilic, positively charged counter ions selected from a tetraalkylammonium hydroxide or salt thereof;
from 5 to 99.95 % by weight of one or more steric hindered amide solvents selected from 1,3-dimethyl-2-piperidone and 1,5-dimethyl-2-piperidone;
from 0 to 95% by weight water or other organic co-solvent;
from 0 to 40% by weight a steric hindered amine or alkanolamine;
from 0 to 40% by weight an organic or inorganic acid;
from 0 to 40% by weight of an other metal corrosion inhibitor compounds;
from 0 to 5 % by weight a surfactant;
from 0 to 5 % by weight of a metal chelating agent; and
from 0 to 10% by weight of a fluoride compound.

There is also provided a process for cleaning a microelectronic substrate having a porous dielectric, a low-κ dielectric, a high-κ dielectric or copper metallisation, the process comprising contacting the substrate with a cleaning composition for a time sufficient to clean the substrate, wherein the cleaning composition comprises a composition according to the invention.

### Detailed Description of the Invention

The novel back end cleaning composition of this invention will comprise one or more of any suitable non-ammonia producing strong base containing non-nucleophilic, positively charged counter ions and one or more of any suitable steric hindered amide solvent stable under strong alkaline conditions. The suitable non-ammonia producing strong base containing non-nucleophilic, positively charged counter ions suitable for use in the cleaning compositions of this invention will be tetraalkylammonium hydroxides or salts thereof; often of the formula:

[(R)₄ N⁺]ₚ[X]^{-q}

where each R is independently a substituted or unsubstituted alkyl, preferably alkyl or hydroxy alkyl of from 1 to 22, and more preferably 1 to 6, carbon atoms (R≠H); and X=OH or a suitable salt anion, such as carbonate and the like; and p and q are equal and are integers of 1 to 3. Other strong bases described include KOH and NaOH. Cleaning compositions containing the non-ammonium producing strong bases containing non-nucleophilic, positively charged counter ions show much improved compatibility with low-κ dielectrics and copper metallization. Ammonia-free tetraalkylammonium hydroxides (TAAH) are very strong bases, yet they have been discovered to provide surprisingly improved low-κ compatibility compared to cleaning compositions with ammonium hydroxide. Especially preferred are tetramethylammonium hydroxide, tetrabutylammonium hydroxide, choline hydroxide and tetramethyl ammonium carbonate.

While previous attempts to control or inhibit metal corrosion have involved careful controlling of pH and/or using corrosion inhibiting compounds, such as benzotriazole (BT), at relatively low concentrations of < 2% by weight, it has been discovered that unexpected, significant improvement in controlling copper metal corrosion can be provided to the cleaning compositions of this invention when one or more steric hindered amide solvent is employed. Suitable steric hindered amide solvent are employed in the cleaning compositions of this invention.

The cleaning compositions of this invention containing the non-ammonia producing strong bases can be formulated into aqueous, semi-aqueous or organic solvent-based compositions. The non-ammonium producing, strong bases containing non-nucleophilic, positively charged counter ions can be used with steric hindered amide solvents alone or in combination with other stable solvents, preferably one or more polar organic solvents resistant to strong bases and that do not contain unhindered nucleophiles, such as dimethyl sulfoxide (DMSO), sulfolane (SFL), dimethyl piperidone, diethanolamine, triethanolamine, 2-(methylamino)ethanol, 3-(dimethylamino)-1,2-propanediol and the like. The cleaning composition may also optionally contain organic or inorganic acids, preferably weak organic or inorganic acids, hindered amines, hindered alkanolamines, and hindered hydroxylamines and other corrosion inhibitors, such as benzotriazole, catechol, glycerol, ethylene glycol and the like. The cleaning compositions may also contain any suitable surfactants, such as for example dimethyl hexynol (Surfynol-61), ethoxylated tetramethyl decynediol (Surfynol-465), polytetrafluoroethylene cetoxypropylbetaine (Zonyl FSK), (Zonyl FSH) and the like. Thus, a wide range of processing/operating pH and temperatures can be used in effectively removing and cleaning photoresists, post plasma etch/ash residues, sacrificial light absorbing materials and anti-reflective coatings (ARC). It has also found that some of this type formulations are particularly effective to clean very difficult samples which contain tantalum in their structure, such as tantalum (Ta) or tantalum nitride barrier layers and tantalum oxides.

Any suitable metal ion-free silicate may be used in the compositions of the present invention. The silicates are preferably quaternary ammonium silicates, such as tetraalkyl ammonium silicate (including hydroxy- and alkoxy-containing alkyl groups generally of from 1 to 4 carbon atoms in the alkyl or alkoxy group). The most preferable metal ion-free silicate component is tetramethyl ammonium silicate. Other suitable metal ion-free silicate sources for this invention may be generated *in-situ* by dissolving any one or more of the following materials in the highly alkaline cleaner. Suitable metal ion-free materials useful for generating silicates in the cleaner are solid silicon wafers, silicic acid, colloidal silica, fumed silica or any other suitable form of silicon or silica. Metal silicates such as sodium metasilicate may be used but are not recommended due to the detrimental effects of metallic contamination on integrated circuits. The silicates may be present in the composition in an amount of from about 0 to 10 wt. %, preferably in an amount of from about 0.1 to about 5 wt. %.

The compositions of the present invention may also be formulated with suitable metal chelating agents to increase the capacity of the formulation to retain metals in solution and to enhance the dissolution of metallic residues on the wafer substrate. The chelating agent will generally be present in the compositions in an amount of from about 0 to 5 wt. %, preferably from an amount of from about 0.1 to 2 wt. %. Typical examples of chelating agents useful for this purpose are the following organic acids and their isomers and salts: (ethylenedinitrilo)tetraacetic acid (EDTA), butylenediaminetetraacetic acid, (1,2-cyclohexylenedinitrilo)tetraacetic acid (CyDTA), diethylenetriaminepentaacetic acid (DETPA), ethylenediaminetetrapropionic acid, (hydroxyethyl)ethylenediaminetriacetic acid (HEDTA), N,N,N',N'-ethylenediaminetetra(methylenephosphonic) acid (EDTMP), triethylenetetraminehexaacetic acid (TTHA), 1,3-diamino-2-hydroxypropane-N,N,N',N'-tetraacetic acid (DHPTA), methyliminodiacetic acid, propylenediaminetetraacetic acid, nitrolotriacetic acid (NTA), citric acid, tartaric acid, gluconic acid, saccharic acid, glyceric acid, oxalic acid, phthalic acid, maleic acid, mandelic acid, malonic acid, lactic acid, salicylic acid, catechol, gallic acid, propyl gallate, pyrogallol, 8-hydroxyquinoline, and cysteine. Preferred chelating agents are aminocarboxylic acids such as EDTA, CyDTA and EDTMP.

The cleaning compositions may also optionally contain fluoride compounds in cleaning composition, such as for example, tetramethylammonium fluoride, tetrabutylammonium fluoride, and ammonium fluoride. Other suitable fluorides include, for example fluoroborates, tetrabutylammonium fluoroborates, aluminum hexafluorides, antimony fluoride and the like. The fluoride components will be present in an amount of from 0 to 10 wt. %, preferably from about 0.1 to 5 wt. %.

The cleaning compositions of this invention comprise from about 0.05 to about 30 wt.% of the non-ammonium producing strong base; from about 5 to about 99.95 wt.% of the steric hindered amide solvent component; from about 0 to about 95 wt.% water or other organic co-solvent; from about 0 to 40 wt.% steric hindered amines or alkanolamines; 0 to 40 wt.% organic or inorganic acids; about 0 to 40 wt.% metal corrosion inhibitor compounds such as benzotriazole, catechol, glycerol, ethylene glycol and the like; from about 0 to 5% wt.% surfactant; from about 0 to 10 wt.% metal ion free silicate; from about 0 to 5 wt. metal chelating agent; and from about 0 to 10 wt.% fluoride compound.

Examples of these types of formulations are set forth in the following **Table 1**.

**TABLE**

| **COM POSITION. PARTS BY WEIGHT** | | | | | | | | |
|---|---|---|---|---|---|---|---|---|
| **COMPONENT** | | **A B C** | | **D** | **E** | **F** | **G** | **H** |
| DMPD | 32 | 16 | 16 | | 20 | | 50 | 16 |
| H₂0 | 32 | 32 | 32 | | | | | 32 |
| TMAH | 16 | 16 | 16 | 10 | 10 | 10 | 10 | 16 |
| TEA | | 16 | | | | | | 15 |
| CyDTA | | 0.2 | | | | | | |
| SFL | | | 16 | | 30 | | | |
| HEP | | | | 50 | | | | |
| NMP | | | | | | 50 | | |
| EDTMP | | | | | | | | 0.4 |

| | | | | | | | | |
|---|---|---|---|---|---|---|---|---|
| DMPD=dimethyl piperidone TMAH= 25% tetramethylammonium hydroxide TEA=triethanolamine CyDTA=trans-1,2-cyclohexanediamine tetraacetic acid SFL=sulfolane H EP=1-(2-hydroxyethyl)-2-pyrrolidinone NMP=N-methyl pyrrolidinone EDTMP=ethylenediamine tetra(methylene phosphonic acid) | | | | | | | | |

The copper etch rates for cleaning Compositions D, E, F G and H of Table 1 are demonstrated by the etch rate data in the following Tables 2 and 3. The etch rate was determined utilizing the following test procedure.

Pieces of copper foil of approximately 13 x 50 mm were employed. The thickness of the foil pieces was measured. After cleaning the foil pieces with 2-propanol, distilled water and acetone and the foil pieces are dried in a drying oven. The cleaned, dried foil pieces were then placed in loosely capped bottles of preheated cleaning compositions of the invention and placed in a vacuum oven for a period of from two to four hours at the indicated temperature. Following treatment and removal from the oven and bottles, the cleaned foils were rinsed with copious amounts of distilled water and dried in a drying oven for about 1 hour and then permitted to cool to room temperature, and then the etch rate determined based on weight loss or weight change.

The results are set forth in **Tables 2 and 3.**

**TABLE 2**

| Composition | Cu Etch Rate (Å/hour) at 70-75 °C (24 hour test) |
|---|---|
| D (comparative) | <10 |
| E | <10 |
| F (comparative) | <10 |
| G | <10 |

**TABLE 3**

| Composition | Cu Etch Rate (Å/hour) at 65 °C (24 hour test) |
|---|---|
| H | 1 |

The cleaning capability of compositions of this invention is illustrated in the following tests in which a microelectronic structure that comprised a wafer of the following structure, namely, PR/ARC/CDO/SiN/Cu Dual Damascene (post trench etch) where PR ="photoresist and ARC= anti-reflective coating, was immersed in cleaning solutions for the indicated temperature and time, were then water rinsed, dried and then the cleaning determined by SEM inspection. The results are set forth in **Table 4.**

**TABLE 4**

| Composition and Process Conditions | Cleaning Performance | Substrate Compatibility |
|---|---|---|
| Composition H 75°C, 20min | 100% Clean; Removed all the PR, ARC and residues | Compatible with Cu and CDO |

## Claims

1. A cleaning composition capable of cleaning residues from porous dielectrics, a low-κ dielectric, a high-κ dielectric or copper metallisation, said cleaning composition comprising:
from 0.05 to 30 % by weight of one or more non-ammonia producing strong base containing non-nucleophilic, positively charged counter ions selected from a tetraalkylammonium hydroxide or salt thereof;
from 5 to 99.95 % by weight of one or more steric hindered amide solvents selected from 1,3-dimethyl-2-piperidone and 1,5-dimethyl-2-piperidone;
from 0 to 95% by weight water or other organic co-solvent;
from 0 to 40% by weight a steric hindered amine or alkanolamine;
from 0 to 40% by weight an organic or inorganic acid;
from 0 to 40% by weight of an other metal corrosion inhibitor compounds;
from 0 to 5 % by weight a surfactant;
from 0 to 5 % by weight of a metal chelating agent; and
from 0 to 10 % by weight of a fluoride compound.

2. A cleaning composition of claim 1 wherein the tetraalkylammonium hydroxide or salt is a compound of the formula:
[(R)₄N⁺]ₚ[X]^{-q}
wherein each R is a substituted or unsubstituted alkyl group and X is OH or a salt anion; and p and q are equal and are integers of from 1 to 3.

3. A cleaning composition of claim 2 wherein R is an alkyl group containing 1 to 22 carbon atoms and X is OH or carbonate.

4. A. cleaning composition of claim 3 wherein R is an alkyl group of from 1 to 6 carbon atoms.

5. A cleaning composition of any preceding claim comprising water or at least one other organic co-solvent selected from the group consisting of dimethyl sulfoxide, sulfolane, diethanolamine, triethanolamine, 2-(methylamino)ethanol and 3-(diethylamino)-1,2-propanediol.

6. A cleaning composition of claim 1 comprising tetramethylammoniun hydroxide, dimethyl piperidone, triethanolamine, trans-1,2-cyclohexanediamine tetraacetic acid and water.

7. A cleaning composition of claim 1 comprising tetramethylammoniun hydroxide, dimethyl piperidone and water.

8. A cleaning composition of claim 1 comprising tetramethylammoniun hydroxide, dimethyl piperidone, triethanolamine, ethylenediamine tetra(methylene phosphonic acid) and water.

9. A process for cleaning a microelectronic substrate having a porous dielectric, a low-κ dielectric, a high-κ dielectric or copper metallisation, the process comprising contacting the substrate with a cleaning composition for a time sufficient to clean the substrate, wherein the cleaning composition comprises a composition of any one of claims 1 to 8.

## Patentansprüche

1. Reinigungszusammensetzung zum Entfernen von Rückständen von porösen Dielektrika, einem Low-k-Dielektrikum, einem High-k-Dielektrikum oder einer Kupfermetallisierung, wobei die Reinigungszusammensetzung umfasst:
von 0,05 bis 30 Gew.-% einer oder mehrerer starken Basen, die keinen Ammoniak erzeugen und nicht nukleophile positiv geladene Gegenionen enthalten, ausgewählt aus einem Tetraaklkylammoniumhydroxid oder einem Salz davon;
von 5 bis 99,99 Gew.-% eines oder mehrerer sterisch gehinderter Amidlösungsmittel ausgewählt aus 1,3-Dimethyl-2-piperidon und 1,5-Dimethyl-2-piperidon;
von 0 bis 95 Gew.-% Wasser oder weitere organische Colösungsmittel;
von 0 bis 40 Gew.-% eines sterisch gehinderten Amins oder Alkanolamins;
von 0 bis 40 Gew.-% einer organischen oder anorganischen Säure;
von 0 bis 40 Gew.-% weiterer Verbindungen zur Inhibieren von Metallkorrosion;
von 0 bis 5 Gew.-% eines Tensids;
von 0 bis 5 Gew.-% eines metallchelatisierenden Reagenzes; und
von 0 bis 10 Gew.-% einer Fluoridverbindung.

2. Reinigungszusammensetzung nach Anspruch 1, wobei das Tetraalkylammoniumhydroxid oder Salz davon eine Verbindung der Formel:
[(R)₄N⁺]ₚ[X]^{-q}
ist, wobei jedes R eine substituierte oder unsubstituierte Alkylgruppe ist und X OH oder ein Salzanion ist; und p und q gleich sind und ganze Zahlen von 1 bis 3 sind.

3. Reinigungszusammensetzung nach Anspruch 2, wobei R eine Alkylgruppe ist, die 1 bis 22 Kohlenstoffatome enthält, und X OH oder Carbonat ist.

4. Reinigungszusammensetzung nach Anspruch 3, wobei R eine Alkylgruppe mit 1 bis 6 Kohlenstoffatomen ist.

5. Reinigungszusammensetzung nach einem der vorherigen Ansprüche, umfassend Wasser oder wenigstens ein weiteres organisches Lösungsmittel, ausgewählt aus der Gruppe bestehend aus Dimethylsulfoxid, Sulfolan, Diethanolamin, Triethanolamin, 2-(Methylamino)ethanol und 3-(Diethylamino)-1,2-propandiol.

6. Reinigungszusammensetzung nach Anspruch 1, umfassend Tetramethylammoniumhydroxid, Dimethylpiperidon, Triethanolamin, Trans-1,2-cyclohexandiamintetraessigsäure und Wasser.

7. Reinigungszusammensetzung nach Anspruch 1, umfassend Tetramethylammoniumhydroxid, Dimethylpiperidon und Wasser.

8. Reinigungszusammensetzung nach Anspruch 1, umfassend Tetramethylammoniumhydroxid, Dimethylpiperidon, Triethanolamin, Ethylendiamintetra(methylenphosphonsäure) und Wasser.

9. Verfahren zum Reinigen eines mikroelektronischen Substrats mit einem porösen Dielektrikum, einem Low-k-Dielektrikum, einem High-k-Dielektrikum oder einer Kupfermetallisierung, wobei das Verfahren In-Kontakt-bringen des Substrats mit einer Reinigungszusammensetzung über einen Zeitraum umfasst, der ausreichend ist das Substrat zu reinigen, wobei die Reinigungszusammensetzung eine Zusammensetzung nach einem der Ansprüche 1 bis 8 umfasst.

## Revendications

1. Composition de nettoyage capable de nettoyer des résidus de composants diélectriques poreux, d'un composant diélectrique à faible κ, d'un composant diélectrique à κ élevé ou d'une métallisation de cuivre, ladite composition de nettoyage comprenant :
de 0,05 à 30 % en poids d'une ou de plusieurs bases fortes ne produisant pas d'ammoniac contenant des contre-ions non nucléophiles, chargés positivement choisis parmi un hydroxyde de tétra-alkylammonium et un sel de celui-ci ;
de 5 à 99,95 % en poids d'un ou de plusieurs solvants de type amide à encombrement stérique choisis parmi la 1,3-diméthyl-2-pipéridone et la 1,5-diméthyl-2-pipéridone ;
de 0 à 95 % en poids d'eau ou d'un autre co-solvant organique ;
de 0 à 40 % en poids d'une amine ou d'une alcanolamine à encombrement stérique ;
de 0 à 40 % en poids d'un acide organique ou minéral ;
de 0 à 40 % en poids d'autres composés inhibiteurs de la corrosion des métaux ;
de 0 à 5 % en poids d'un tensioactif ;
de 0 à 5 % en poids d'un agent chélatant les métaux ; et
de 0 à 10 % en poids d'un fluorure.

2. Composition de nettoyage selon la revendication 1, dans laquelle l'hydroxyde de tétra-alkylammonium ou son sel est un composé de formule :
[(R)₄N⁺]ₚ[X]^{-q}
dans laquelle chaque R est un groupe alkyle substitué ou non substitué et X est OH ou un anion de type sel ; et p et q sont égaux et sont des nombres entiers de 1 à 3.

3. Composition de nettoyage selon la revendication 2, dans laquelle R est un groupe alkyle contenant 1 à 22 atomes de carbone et X est OH ou un carbonate.

4. Composition de nettoyage selon la revendication 3, dans laquelle R est un groupe alkyle de 1 à 6 atomes de carbone.

5. Composition de nettoyage selon l'une quelconque des revendications précédentes, comprenant de l'eau ou au moins un autre co-solvant organique choisi dans le groupe constitué par le diméthylsulfoxyde, le sulfolane, la diéthanolamine, la triéthanolamine, le 2-(méthylamino)éthanol et le 3-(diéthylamino)-1,2-propanediol.

6. Composition de nettoyage selon la revendication 1, comprenant de l'hydroxyde de tétraméthylammonium, de la diméthylpipéridone, de la triéthanolamine, de l'acide trans-1,2-cyclohexanediamine-tétraacétique et de l'eau.

7. Composition de nettoyage selon la revendication 1, comprenant de l'hydroxyde de tétraméthylammonium, de la diméthylpipéridone et de l'eau.

8. Composition de nettoyage selon la revendication 1, comprenant de l'hydroxyde de tétraméthylammonium, de la diméthylpipéridone, de la triéthanolamine, de l'éthylènediamine-tétra(acide méthylènephosphonique) et de l'eau.

9. Procédé de nettoyage d'un substrat micro-électronique comprenant un composant diélectrique poreux, un composant diélectrique à faible κ, un composant diélectrique à κ élevé ou une métallisation de cuivre, le procédé comprenant la mise en contact du substrat avec une composition de nettoyage pendant un temps suffisant pour nettoyer le substrat, dans lequel la composition de nettoyage comprend une composition telle que définie à l'une quelconque des revendications 1 à 8.
